# EUROPEAN PATENT APPLICATION

(11) **EP 2 615 604 A1**
(43) Date of publication of application: **17.07.2013**
(21) Application number: 12167374.3
(22) Date of filing: 09.05.2012
(51) Int. Cl.: G09G 3/32

(54) **Organic light emitting display device and method of driving organic light emitting display device**

(30) Priority: 13.01.2012 KR 20120004412
(71) Applicant: Samsung Display Co., Ltd., Yongin-City, Gyeonggi-Do, 446-711 (KR)
(72) Inventor: Lee, Hae-Yeon, 446-711 Gyunggi-Do (KR); Lee, Wang-Jo, 446-711 Gyunggi-Do (KR); Kim, Yong-Jae, 446-711 Gyunggi-Do (KR); Oh, Jin-Gon, 446-711 Gyunggi-Do (KR)
(74) Representative: Walaski, Jan Filip

(57) **Abstract**

An organic light emitting display device includes a pixel unit, a scan driver, a data driver and a voltage generation unit. The pixel unit includes a plurality of pixels coupled to a plurality of scan lines and a plurality of data lines, where each of the pixels includes an organic light emitting diode. The voltage generation unit is coupled to the pixel unit through one power line which provides the common supply voltage to the pixels. Each of the plurality of pixels includes a voltage drop unit, each voltage drop unit generates a respective drive voltage by dropping a voltage of the common supply voltage, and turns on the organic light emitting diode to emit light with a luminance corresponding to a voltage of the drive voltage based on a logic level of the data signal. The organic light emitting display device increases an aperture ratio.

## Description

The invention relates to an organic light emitting display device, and more particularly to an organic light emitting display device that is driven in a digital manner, a system including the organic light emitting display device and method of driving the organic light emitting display device.

Various flat panel displays with reduced weight and volume in comparison to a cathode ray tube display have been developed. The various flat panel displays include a liquid crystal display (LCD), a field emission display (FED), a plasma display panel (PDP), an organic light emitting display (OLED), etc. Among the various flat panel displays, the organic light emitting display (OLED), which displays an image using organic light emitting diodes that emit light by a recombination of electrons and holes, has a rapid response speed and low power consumption.

Generally, the organic light emitting display (OLED) includes a plurality of scan lines, a plurality of data lines, and a plurality of pixels that are coupled to the plurality of scan lines and the plurality of data lines and arranged in a matrix form. Also, each of the pixels generally includes an organic light emitting diode, two transistors, e.g., a switching transistor that transfers a data signal and a driving transistor that drives the organic light emitting diode according to the data signal, and a capacitor that maintains the data signal.

The organic light emitting display (OLED) may be driven in an analog manner or in a digital manner.

In an analog driving manner, a voltage that is applied to an organic light emitting diode is determined according to a voltage of the data signal so that the organic light emitting diode emits light with a luminance corresponding to a voltage of the data signal. That is, in an analog driving manner, light emitting durations of the plurality of pixels are the same, but a luminance of each of the plurality of pixels is controlled by adjusting a current, which flows through the organic light emitting diode, based on a voltage of the data signal to display a gray scale.

Therefore, the organic light emitting display (OLED) may not display a gray scale accurately in an analog driving manner, since a gray scale is sensitive to characteristics of the driving transistor and the organic light emitting diode.

On the other hand, in a digital driving manner, luminance of the plurality of pixels are the same since a constant voltage, which is determined according to a supply voltage, is applied to an organic light emitting diode, but a light emitting duration of each of the plurality of pixels is controlled by adjusting a turn on duration of the driving transistor using the data signal.

Therefore, the organic light emitting display (OLED) may display a gray scale accurately in a digital driving manner, since a gray scale is not sensitive to characteristics of the driving transistor and the organic light emitting diode.

However, in a digital driving manner, voltages of the supply voltage provided to a red pixel, a green pixel and a blue pixel should be different from each other for a white balance. Therefore, a conventional organic light emitting display (OLED) that is driven in a digital manner requires three supply voltages, so that three power lines are formed in a pixel unit. As such, in a conventional organic light emitting display (OLED), an aperture ratio may be reduced because of the three power lines, a dead space may be increased because of complicated wirings of the three power lines, and the three power lines may be easily shorted with each other since the three power lines are formed to overlap on the pixel unit.

Example embodiments are directed to provide an organic light emitting display device that is driven in a digital manner using one supply voltage.

Example embodiments are directed to provide a system including the organic light emitting display device.

Example embodiments are directed to provide a method of driving the organic light emitting display device.

According to example embodiments, an organic light emitting display device includes a pixel unit, a scan driver, a data driver and a voltage generation unit. The pixel unit includes a plurality of pixels coupled to a plurality of scan lines and a plurality of data lines, where each of the plurality of pixels includes an organic light emitting diode and turns on the organic light emitting diode to emit light using a common supply voltage. The scan driver provides a scan signal to the plurality of pixels through the plurality of scan lines. The data driver provides a data signal to the plurality of pixels through the plurality of data lines, where the data signal has one of a first logic level and a second logic level. The voltage generation unit is coupled to the pixel unit through one power line, and provides the common supply voltage to the plurality of pixels through the one power line.

In example embodiments, each of the plurality of pixels may include a voltage drop unit, which generates a drive voltage by dropping a voltage of the common supply voltage, and turn on the organic light emitting diode to emit light with a luminance corresponding to a voltage of the drive voltage based on a logic level of the data signal.

The plurality of pixels may include a red pixel, a green pixel and a blue pixel, and the voltage drop units included in the red pixel, the green pixel and the blue pixel may generate the drive voltages having different voltages from each other.

The voltage drop unit may include a metal oxide semiconductor (MOS) transistor connected to the common supply voltage.

Aspect ratios of the MOS transistors included in the red pixel, the green pixel and the blue pixel may be different from each other.

The voltage drop unit may include a resistor connected to the common supply voltage.

Resistances of the resistors included in the red pixel, the green pixel and the blue pixel may be different from each other.

In example embodiments, each of the plurality of pixels may include an organic light emitting diode having a cathode connected to a ground voltage, a first p-type metal oxide semiconductor (PMOS) transistor having a gate electrode, a first electrode and a second electrode coupled to an anode of the organic light emitting diode, a voltage drop unit generating a drive voltage by dropping a voltage of the common supply voltage and providing the drive voltage to the first electrode of the first PMOS transistor, a second PMOS transistor having a first electrode coupled to the data line, a second electrode coupled to the gate electrode of the first PMOS transistor and a gate electrode coupled to the scan line, and a storage capacitor coupled between the gate electrode of the first PMOS transistor and the first electrode of the first PMOS transistor.

The plurality of pixels may include a red pixel, a green pixel and a blue pixel, and the voltage drop units included in the red pixel, the green pixel and the blue pixel may generate the drive voltages having different voltages from each other.

The voltage drop units included in the red pixel, the green pixel and the blue pixel may provide loads having different resistances from each other between the common supply voltage and the first electrode of the first PMOS transistor.

The voltage drop unit may include a third PMOS transistor having a first electrode connected to the common supply voltage, a second electrode coupled to the first electrode of the first PMOS transistor and a gate electrode coupled to the second electrode of the second PMOS transistor.

Aspect ratios of the third PMOS transistors included in the red pixel, the green pixel and the blue pixel may be different from each other.

The voltage drop unit may include a resistor coupled between the common supply voltage and the first electrode of the first PMOS transistor.

Resistances of the resistors included in the red pixel, the green pixel and the blue pixel may be different from each other.

In example embodiments, each of the plurality of pixels may include an organic light emitting diode having a cathode connected to a ground voltage, a first p-type metal oxide semiconductor (PMOS) transistor having a gate electrode, a first electrode and a second electrode coupled to an anode of the organic light emitting diode, a voltage drop unit generating a drive voltage by dropping a voltage of the common supply voltage and providing the drive voltage to the first electrode of the first PMOS transistor, a second PMOS transistor having a first electrode coupled to the data line, a second electrode coupled to the gate electrode of the first PMOS transistor and a gate electrode coupled to the scan line, and a storage capacitor coupled between the gate electrode of the first PMOS transistor and the common supply voltage.

In a method of driving an organic light emitting display device that includes a plurality of pixels coupled to a plurality of scan lines and a plurality of data lines and including an organic light emitting diode, a common supply voltage is provided to the plurality of pixels through one power line, a scan signal is provided to the plurality of pixels through the plurality of scan lines, and a data signal, which has one of a first logic level and a second logic level, is provided to the plurality of pixels through the plurality of data lines. At pixels among the plurality of pixels that receive the data signal having the first logic level, a drive voltage is generated by dropping a voltage of the common supply voltage and the organic light emitting diode is turned on to emit light with a luminance corresponding to a voltage of the drive voltage. At pixels among the plurality of pixels that receive the data signal having the second logic level, the organic light emitting diode is turned off.

The plurality of pixels may include a red pixel, a green pixel and a blue pixel. At the red pixel among the plurality of pixels that receives the data signal having the first logic level, a first drive voltage may be generated by dropping a voltage of the common supply voltage and the organic light emitting diode may be turned on to emit light with a luminance corresponding to a voltage of the first drive voltage. At the green pixel among the plurality of pixels that receives the data signal having the first logic level, a second drive voltage may be generated by dropping a voltage of the common supply voltage and the organic light emitting diode may be turned on to emit light with a luminance corresponding to a voltage of the second drive voltage. At the blue pixel among the plurality of pixels that receives the data signal having the first logic level, a third drive voltage may be generated by dropping a voltage of the common supply voltage and the organic light emitting diode may be turned on to emit light with a luminance corresponding to a voltage of the third drive voltage.

The red pixel may generate the first drive voltage by dropping a voltage of the common supply voltage using a first MOS transistor, the green pixel may generate the second drive voltage by dropping a voltage of the common supply voltage using a second MOS transistor, and the blue pixel may generate the third drive voltage by dropping a voltage of the common supply voltage using a third MOS transistor. Aspect ratios of the first MOS transistor, the second MOS transistor and the third MOS transistor may be different from each other.

The red pixel may generate the first drive voltage by dropping a voltage of the common supply voltage using a first resistor, the green pixel may generate the second drive voltage by dropping a voltage of the common supply voltage using a second resistor, and the blue pixel may generate the third drive voltage by dropping a voltage of the common supply voltage using a third resistor. Resistances of the first resistor, the second resistor and the third resistor may be different from each other.

According to example embodiments, a system includes a storage device, an organic light emitting display device and a processor. The storage device stores video data. The organic light emitting display device displays the video data. The processor controls the storage device and the organic light emitting display device. The organic light emitting display device includes a pixel unit, a scan driver, a data driver and a voltage generation unit. The pixel unit includes a plurality of pixels coupled to a plurality of scan lines and a plurality of data lines, where each of the plurality of pixels includes an organic light emitting diode and turns on the organic light emitting diode to emit light using a common supply voltage. The scan driver provides a scan signal to the plurality of pixels through the plurality of scan lines. The data driver provides a data signal to the plurality of pixels through the plurality of data lines, where the data signal has one of a first logic level and a second logic level. The voltage generation unit is coupled to the pixel unit through one power line, and provides the common supply voltage to the plurality of pixels through the one power line.

A more complete appreciation of the invention, and many of the attendant advantages thereof, will be readily apparent as the same becomes better understood by reference to the following detailed description when considered in conjunction with the accompanying drawings, in which like reference symbols indicate the same or similar components, wherein:
FIG. 1 is a block diagram illustrating an organic light emitting display device according to example embodiments;
FIGS. 2, 3 and 4 are circuit diagrams illustrating examples of a pixel included in an organic light emitting display device of FIG. 1;
FIGS. 5, 6 and 7 are circuit diagrams illustrating examples of a voltage drop unit included in pixels of FIGS. 2, 3 and 4, respectively;
FIGS. 8, 9 and 10 are circuit diagrams illustrating other examples of a voltage drop unit included in pixels of FIGS. 2, 3 and 4, respectively;
FIGS. 11, 12 and 13 are circuit diagrams illustrating other examples of a pixel included in an organic light emitting display device of FIG. 1;
FIGS. 14, 15 and 16 are circuit diagrams illustrating examples of a voltage drop unit included in pixels of FIGS. 11, 12 and 13, respectively;
FIGS. 17, 18 and 19 are circuit diagrams illustrating other examples of a voltage drop unit included in pixels of FIGS. 11, 12 and 13, respectively;
FIGS. 20 and 21 are diagrams for describing advantages of an organic light emitting display device of FIG. 1;
FIG. 22 is a flow chart illustrating a method of driving an organic light emitting display device according to example embodiments;
FIG. 23 is a flow chart illustrating an example of a step of generating a drive voltage and turning on the organic light emitting diode in a method of FIG. 22; and
FIG. 24 is a block diagram illustrating a system including an organic light emitting display device according to example embodiments.

Various example embodiments will be described more fully with reference to the accompanying drawings.

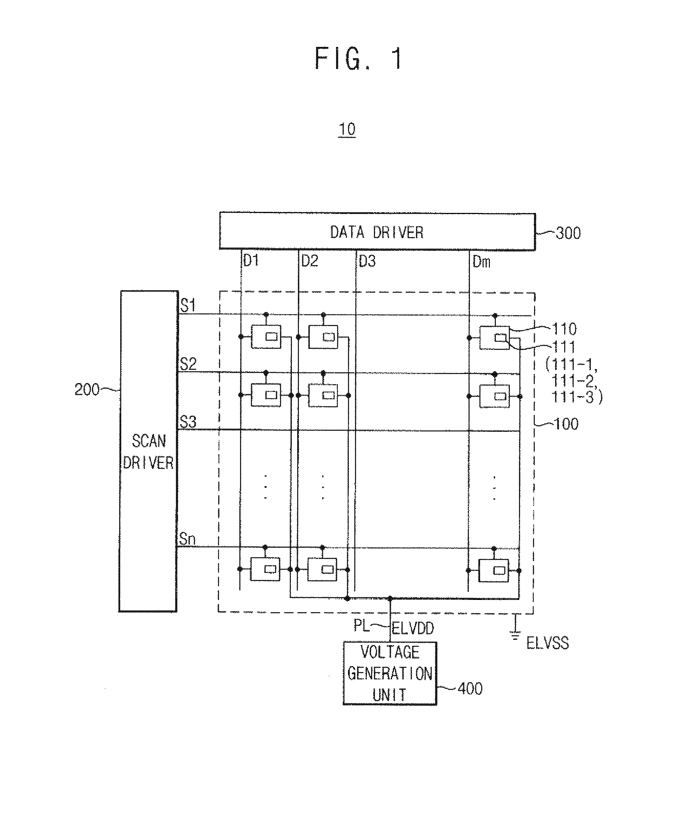

FIG. 1 is a block diagram illustrating an organic light emitting display device according to example embodiments.

Referring to FIG. 1, an organic light emitting display device 10 includes a pixel unit 100, a scan driver 200, a data driver 300 and a voltage generation unit 400.

The pixel unit 100 is coupled to the scan driver 200 through a plurality of scan lines S1, S₂, ..., Sn (n is a positive integer). The pixel unit 100 is coupled to the data driver 300 through a plurality of data lines D1, D2, ..., Dm (m is a positive integer). The pixel unit 100 is coupled to the voltage generation unit 400 through one power line PL. The pixel unit 100 is connected to a ground voltage ELVSS.

The pixel unit 100 includes a plurality of pixels 110 coupled to the plurality of scan lines S1, S2, ..., Sn and the plurality of data lines D1, D2, ..., Dm. Each of the plurality of pixels 110 includes an organic light emitting diode.

The scan driver 200 provides scan signals to the plurality of pixels 110 through the plurality of scan lines S1, S2, ..., Sn.

The data driver 300 provides data signals to the plurality of pixels 110 through the plurality of data lines D1, D2, ..., Dm. The data signals have one of a first logic level and a second logic level. The first logic level may be a logic high level and the second logic level may be a logic low level. Alternatively, the first logic level may be a logic low level and the second logic level may be a logic high level.

The voltage generation unit 400 generates a common supply voltage ELVDD and provides the common supply voltage ELVDD to the plurality of pixels 110 through the one power line PL.

Each of the plurality of pixels 110 receives the common supply voltage ELVDD from the voltage generation unit 400 and turns on the organic light emitting diode to emit light using the common supply voltage ELVDD.

In some example embodiments, each of the plurality of pixels 110 may include a voltage drop unit 111 that generates a drive voltage by dropping a voltage of the common supply voltage ELVDD. Each of the plurality of pixels 110 may turn on the organic light emitting diode to emit light with a luminance corresponding to a voltage of the drive voltage based on a logic level of the data signal.

The plurality of pixels 110 may include a red pixel, a green pixel and a blue pixel. The voltage drop units 111 included in the red pixel, the green pixel and the blue pixel may generate the drive voltages having different voltages from each other.

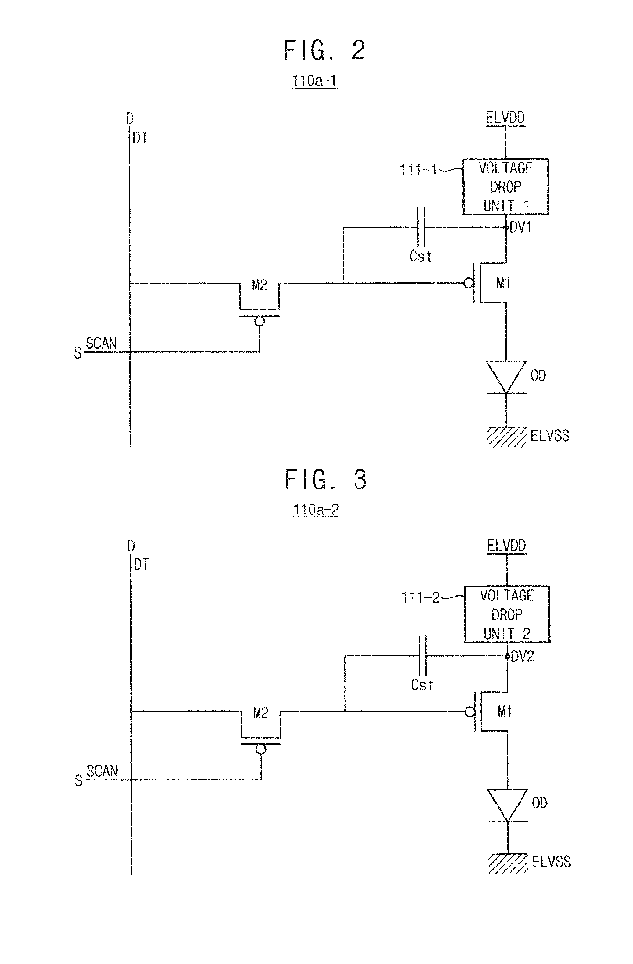

For example, as illustrated in FIGS. 2, 3 and 4, respectively, the red pixel may include a voltage drop unit 111-1 that generates a first drive voltage by dropping a voltage of the common supply voltage ELVDD, the green pixel may include a voltage drop unit 111-2 that generates a second drive voltage by dropping a voltage of the common supply voltage ELVDD, and the blue pixel may include a voltage drop unit 111-3 that generates a third drive voltage by dropping a voltage of the common supply voltage ELVDD. Voltages of the first drive voltage, the second drive voltage and the third drive voltage may be different from each other.

The voltage drop unit 111-1, the voltage drop unit 111-2 and the voltage drop unit 111-3 may have different resistances from each other so that the voltage drop unit 111-1, the voltage drop unit 111-2 and the voltage drop unit 111-3 may generate the first drive voltage, the second drive voltage and the third drive voltage, which have different voltages from each other, by dropping a voltage of the common supply voltage ELVDD.

Since voltages of the first drive voltage, the second drive voltage and the third drive voltage may be different from each other, luminance of light emitted from the red pixel, the green pixel and the blue pixel may be different from each other.

The organic light emitting display device 10 is driven in a digital manner. That is, the organic light emitting display device 10 displays a gray scale by controlling a light emitting duration of each of the plurality of pixels 110 based on a logic level of the data signal.

Hereinafter, an exemplary operation of the organic light emitting display device 10 that is driven in a digital manner will be described. However, embodiments are not limited thereto.

The data driver 300 may receive a video data for one frame, determine a gray scale of a luminance for each of the plurality of pixels 110, and convert the gray scale of a luminance into a digital data having a predetermined number of bits for each of the plurality of pixels 110.

One frame may include the predetermined number of sub-frames. That is, the number of sub-frames included in one frame may be the same as the number of bits included in the digital data, and each bit of the digital data may correspond to each of the sub-frames, respectively. Durations of the sub-frames may be different from each other.

The scan driver 200 may provide the scan signal to the plurality of scan lines S1, S2, ..., Sn consecutively for each of the sub-frames, and the data driver 300 may provide one bit of the digital data to the plurality of pixels 110 during a corresponding sub-frame as the data signal. Therefore, the data signal provided to each of the plurality of pixels 110 for each of the sub-frames may have one of a logic high level and a logic low level.

Each of the plurality of pixels 110 may turn on the organic light emitting diode to emit light during a corresponding sub-frame when receiving the data signal having a logic low level, and turn off the organic light emitting diode not to emit light during the corresponding sub-frame when receiving the data signal having a logic high level. Alternatively, each of the plurality of pixels 110 may turn on the organic light emitting diode to emit light during a corresponding sub-frame when receiving the data signal having a logic high level, and turn off the organic light emitting diode not to emit light during the corresponding sub-frame when receiving the data signal having a logic low level.

That is, the data driver 300 may provide the data signal having one of a logic high level and a logic low level to the plurality of pixels 110 during each sub-frame, so that the organic light emitting display device 10 may display a gray scale by controlling a light emitting duration in one frame while a luminance of the light is maintained constantly.

Therefore, luminance of the light emitted from the red pixel, the green pixel and the blue pixel may be required to be determined differently from each other for a white balance.

For this, a conventional organic light emitting display device uses an independent supply voltage for each of the red pixel, the green pixel and the blue pixel. Therefore, three power lines for each of the three supply voltages would be formed on the pixel unit. As such, in the conventional organic light emitting display device, an aperture ratio may be reduced because of the three power lines formed on the pixel unit, a dead space may be increased because of complicated wirings of the three power lines, and the three power lines may be easily shorted with each other since the three power lines are formed to overlap on the pixel unit. An aperture ratio represents a ratio of an area through which light comes out to a total area of the pixel unit.

On the other hand, in the organic light emitting display device 10 according to example embodiments, the voltage generation unit 400 generates the common supply voltage ELVDD and provides the common supply voltage ELVDD to the plurality of pixels 110 through the one power line PL, and each of the plurality of pixels 110 receives the common supply voltage ELVDD from the voltage generation unit 400 and turns on the organic light emitting diode to emit light using the common supply voltage ELVDD.

In addition, for a white balance, a red pixel, a green pixel and a blue pixel, which are included in the plurality of pixels 110, may include the voltage drop unit 111-1, the voltage drop unit 111-2 and the voltage drop unit 111-3, respectively, that generate the drive voltages having different voltages from each other by dropping a voltage of the common supply voltage ELVDD. Therefore, luminance of the light emitted from the red pixel, the green pixel and the blue pixel may be determined differently from each other.

As such, in the organic light emitting display device 10 according to example embodiments, only one power line PL may be formed on the pixel unit 100, such that an aperture ratio may be increased, a dead space may be reduced, and a short between wirings may be reduced.

FIGS. 2, 3 and 4 are circuit diagrams illustrating respective examples of a pixel included in an organic light emitting display device of FIG. 1.

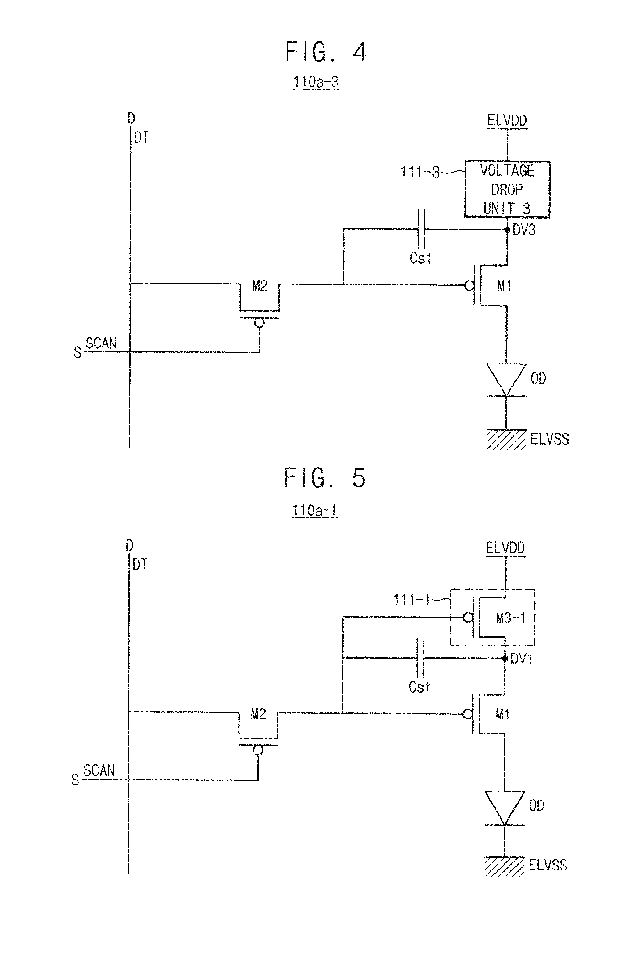

FIG. 2 is a circuit diagram illustrating an example of a red pixel included in the organic light emitting display device 10, FIG. 3 is a circuit diagram illustrating an example of a green pixel included in the organic light emitting display device 10, and FIG. 4 is a circuit diagram illustrating an example of a blue pixel included in the organic light emitting display device 10.

Referring to FIG. 2, a red pixel 110a-1 may receive the scan signal SCAN from the scan driver 200 of FIG. 1 through the scan line S. The red pixel 110a-1 may receive the data signal DT from the data driver 300 of FIG. 1 through the data line D. The red pixel 110a-1 may receive the common supply voltage ELVDD from the voltage generation unit 400 of FIG. 1 through the power line PL.

The red pixel 110a-1 may include an organic light emitting diode OD, a p-type metal oxide semiconductor (PMOS) transistor M1, a PMOS transistor M2, a voltage drop unit 111-1 and a storage capacitor Cst.

The organic light emitting diode OD may include a cathode connected to the ground voltage ELVSS and an anode coupled to a second electrode of the PMOS transistor M1.

The PMOS transistor M1 may include a first electrode coupled to the voltage drop unit 111-1, the second electrode coupled to the anode of the organic light emitting diode OD, and a gate electrode coupled to a second electrode of the PMOS transistor M2. The PMOS transistor M1 may operate as a driving transistor.

The voltage drop unit 111-1 may be coupled between the common supply voltage ELVDD and the first electrode of the PMOS transistor M1. The voltage drop unit 111-1 may generate a drive voltage DV1 by dropping a voltage of the common supply voltage ELVDD and provide the drive voltage DV1 to the first electrode of the PMOS transistor M1.

The PMOS transistor M2 may include a first electrode coupled to the data line D, the second electrode coupled to the gate electrode of the PMOS transistor M1, and a gate electrode coupled to the scan line S. The PMOS transistor M2 may operate as a switching transistor.

The storage capacitor Cst may include a first electrode coupled to the gate electrode of the PMOS transistor M1 and a second electrode coupled to the first electrode of the PMOS transistor M1.

Referring to FIG. 3, a green pixel 110a-2 may receive the scan signal SCAN from the scan driver 200 of FIG. 1 through the scan line S. The green pixel 110a-2 may receive the data signal DT from the data driver 300 of FIG. 1 through the data line D. The green pixel 110a-2 may receive the common supply voltage ELVDD from the voltage generation unit 400 of FIG. 1 through the power line PL.

The green pixel 110a-2 may include an organic light emitting diode OD, a p-type metal oxide semiconductor (PMOS) transistor M1, a PMOS transistor M2, a voltage drop unit 111-2 and a storage capacitor Cst.

The green pixel 110a-2 of FIG. 3 may have the same structure as the red pixel 110a-1 of FIG. 2 except that the green pixel 110a-2 includes the voltage drop unit 111-2 instead of the voltage drop unit 111-1. A structure and an operation of the red pixel 110a-1 of FIG. 2 are described above with reference to FIGS. 1 and 2. Therefore, a duplicated description of the green pixel 110a-2 of FIG. 3 will be omitted.

The voltage drop unit 111-2 may be coupled between the common supply voltage ELVDD and the first electrode of the PMOS transistor M1. The voltage drop unit 111-2 may generate a drive voltage DV2 by dropping a voltage of the common supply voltage ELVDD and provide the drive voltage DV2 to the first electrode of the PMOS transistor M1. A voltage of the drive voltage DV2 generated by the voltage drop unit 111-2 may be different from a voltage of the drive voltage DV1 generated by the first voltage drop unit 111-1.

Referring to FIG. 4, a blue pixel 110a-3 may receive the scan signal SCAN from the scan driver 200 of FIG. 1 through the scan line S. The blue pixel 110a-3 may receive the data signal DT from the data driver 300 of FIG. 1 through the data line D. The blue pixel 110a-3 may receive the common supply voltage ELVDD from the voltage generation unit 400 of FIG. 1 through the power line PL.

The blue pixel 110a-3 may include an organic light emitting diode OD, a p-type metal oxide semiconductor (PMOS) transistor M1, a PMOS transistor M2, a voltage drop unit 111-3 and a storage capacitor Cst.

The blue pixel 110a-3 of FIG. 4 may have the same structure as the red pixel 110a-1 of FIG. 2 except that the blue pixel 110a-3 includes the voltage drop unit 111-3 instead of the voltage drop unit 111-1. A structure and an operation of the red pixel 110a-1 of FIG. 2 are described above with reference to FIGS. 1 and 2. Therefore, a duplicated description of the blue pixel 110a-3 of FIG. 4 will be omitted.

The voltage drop unit 111-3 may be coupled between the common supply voltage ELVDD and the first electrode of the PMOS transistor M1. The voltage drop unit 111-3 may generate a drive voltage DV3 by dropping a voltage of the common supply voltage ELVDD and provide the drive voltage DV3 to the first electrode of the PMOS transistor M1. A voltage of the drive voltage DV3 generated by the voltage drop unit 111-3 may be different from a voltage of the drive voltage DV1 generated by the voltage drop unit 111-1 and a voltage of the drive voltage DV2 generated by the voltage drop unit 111-2.

The voltage drop unit 111-1, the voltage drop unit 111-2 and the voltage drop unit 111-3 may provide loads having different resistances from each other between the common supply voltage ELVDD and the first electrode of the PMOS transistor M1, so that the voltage drop unit 111-1, the voltage drop unit 111-2 and the voltage drop unit 111-3 may generate the drive voltage DV1, the drive voltage DV2 and the drive voltage DV3, respectively, having different voltages from each other.

Hereinafter, operations of the red pixel 110a-1, the green pixel 110a-2 and the blue pixel 110a-3 will be described with reference to FIGS. 1 to 4.

When the PMOS transistor M2, which operates as a switching transistor, is turned on in response to the scan signal SCAN provided from the scan driver 200 through the scan line S, the data signal DT provided from the data driver 300 through the data line D may be applied to the gate electrode of the PMOS transistor M1 and to the first electrode of the storage capacitor Cst.

The storage capacitor Cst may store a voltage difference between the drive voltage DV1 and the data signal DT.

When the data signal DT is in a logic low level, the PMOS transistor M1, which operates as a driving transistor, may be turned on. In the red pixel 110a-1, the drive voltage DV1 may be applied to the anode of the organic light emitting diode OD so that the organic light emitting diode OD emits light with a luminance corresponding to a voltage of the drive voltage DV1. In the green pixel 110a-2, the drive voltage DV2 may be applied to the anode of the organic light emitting diode OD so that the organic light emitting diode OD emits light with a luminance corresponding to a voltage of the drive voltage DV₂. In the blue pixel 110a-3, the drive voltage DV3 may be applied to the anode of the organic light emitting diode OD so that the organic light emitting diode OD emits light with a luminance corresponding to a voltage of the drive voltage DV3.

When the data signal DT is in a logic high level, the PMOS transistor M1, which operates as a driving transistor, may be turned off so that the organic light emitting diode OD does not emit light.

As described above, one frame may include the predetermined number of sub-frames, and the red pixel 110a-1, the green pixel 110a-2 and the blue pixel 110a-3 may selectively emit light during each sub-frame based on a logic level of the data signal DT. Therefore, the organic light emitting display device 10 may display a gray scale by controlling a light emitting duration of the red pixel 110a-1, the green pixel 110a-2 and the blue pixel 110a-3 in one frame based on the data signal DT.

In addition, the red pixel 110a-1 may include the voltage drop unit 111-1 that generates the drive voltage DV1 by dropping a voltage of the common supply voltage ELVDD, the green pixel 110a-2 may include the voltage drop unit 111-2 that generates the drive voltage DV2 by dropping a voltage of the common supply voltage ELVDD, and the blue pixel 110a-3 may include the voltage drop unit 111-3 that generates the drive voltage DV3 by dropping a voltage of the common supply voltage ELVDD. Therefore, the organic light emitting display device 10 may adjust a white balance by independently controlling luminance of the light emitted from the red pixel 110a-1, the green pixel 110a-2 and the blue pixel 110a-3 using the voltage drop unit 111-1, the voltage drop unit 111-2 and the voltage drop unit 111-3.

FIGS. 5, 6 and 7 are circuit diagrams illustrating an example of a voltage drop unit included in pixels of FIGS. 2, 3 and 4, respectively.

Referring to FIG. 5, the voltage drop unit 111-1 may include a PMOS transistor M3-1 having a first electrode connected to the common supply voltage ELVDD, a second electrode coupled to the first electrode of the PMOS transistor M1 and a gate electrode coupled to the second electrode of the PMOS transistor M2.

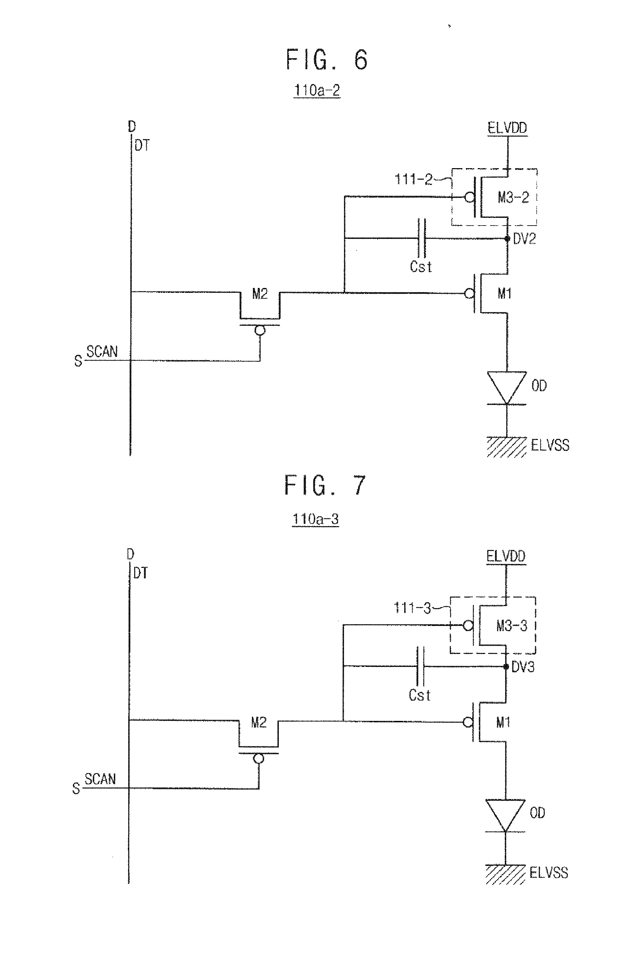

Referring to FIG. 6, the voltage drop unit 111-2 may include a PMOS transistor M3-2 having a first electrode connected to the common supply voltage ELVDD, a second electrode coupled to the first electrode of the PMOS transistor M1 and a gate electrode coupled to the second electrode of the PMOS transistor M2.

Referring to FIG. 7, the voltage drop unit 111-3 may include a PMOS transistor M3-3 having a first electrode connected to the common supply voltage ELVDD, a second electrode coupled to the first electrode of the PMOS transistor M1 and a gate electrode coupled to the second electrode of the PMOS transistor M2.

Aspect ratios of the PMOS transistor M3-1, the PMOS transistor M3-2 and the PMOS transistor M3-3 may be different from each other. An aspect ratio of a MOS transistor represents a ratio of a channel width to a channel length.

When the data signal DT is in a logic low level, the PMOS transistor M3-1, the PMOS transistor M3-2 and the PMOS transistor M3-3 may be turned on. Therefore, the PMOS transistor M3-1, the PMOS transistor M3-2 and the PMOS transistor M3-3 may generate the drive voltage DV1, the drive voltage DV2 and the drive voltage DV3, respectively, having different voltages from each other by providing loads having different resistances from each other between the common supply voltage ELVDD and the first electrode of the PMOS transistor M1. The PMOS transistor M3-1, the PMOS transistor M3-2 and the PMOS transistor M3-3 may provide the drive voltage DV1, the drive voltage DV2 and the drive voltage DV3, respectively, to the first electrode of the PMOS transistor M1.

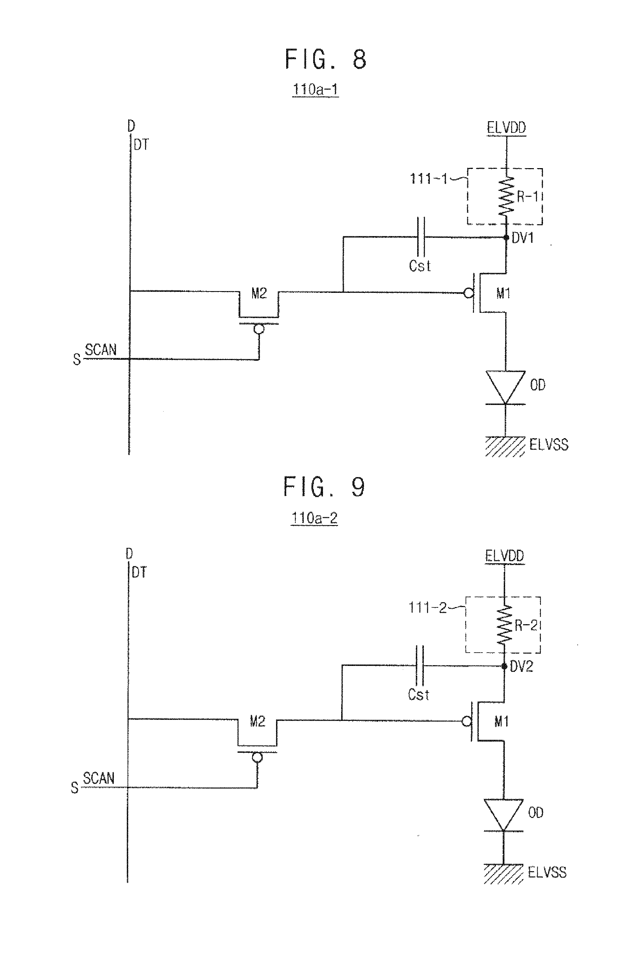

FIGS. 8, 9 and 10 are circuit diagrams illustrating another example of a voltage drop unit included in pixels of FIGS. 2, 3 and 4, respectively.

Referring to FIG. 8, the voltage drop unit 111-1 may include a resistor R-1 coupled between the common supply voltage ELVDD and the first electrode of the PMOS transistor M1.

Referring to FIG. 9, the voltage drop unit 111-2 may include a resistor R-2 coupled between the common supply voltage ELVDD and the first electrode of the PMOS transistor M1.

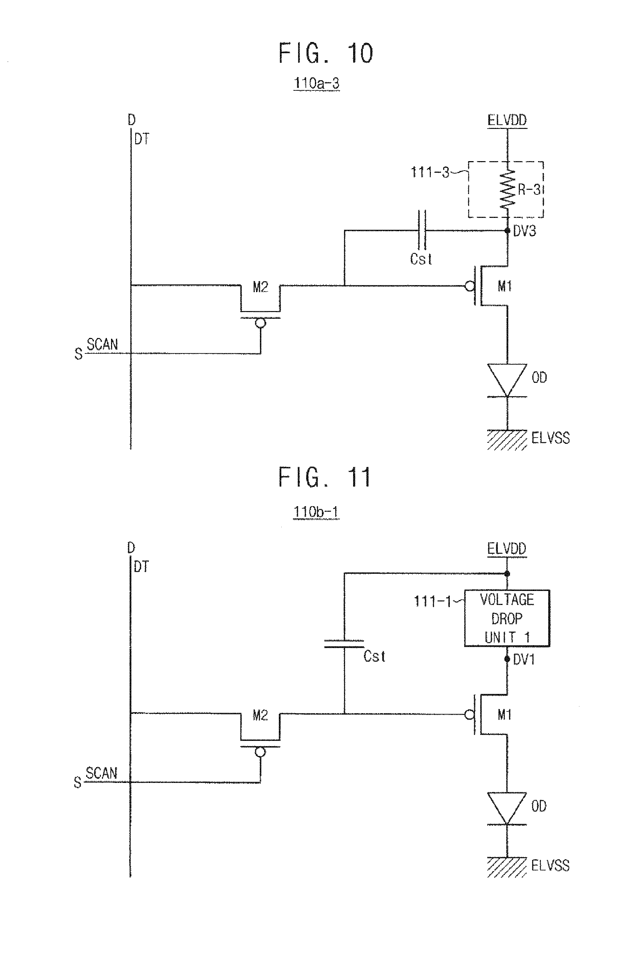

Referring to FIG. 10, the voltage drop unit 111-3 may include a resistor R-3 coupled between the common supply voltage ELVDD and the first electrode of the PMOS transistor M1.

Resistance values of the resistor R-1, the resistor R-2 and the resistor R-3 may be different from each other.

Therefore, the resistor R-1, the resistor R-2 and the resistor R-3 may generate the drive voltage DV1, the drive voltage DV2 and the drive voltage DV3, respectively, having different voltages from each other by providing loads having different resistances from each other between the common supply voltage ELVDD and the first electrode of the PMOS transistor M1. The resistor R-1, the resistor R-2 and the resistor R-3 may provide the drive voltage DV1, the drive voltage DV2 and the drive voltage DV3, respectively, to the first electrode of the PMOS transistor M1.

FIGS. 11, 12 and 13 are circuit diagrams illustrating another example of a pixel included in an organic light emitting display device of FIG. 1.

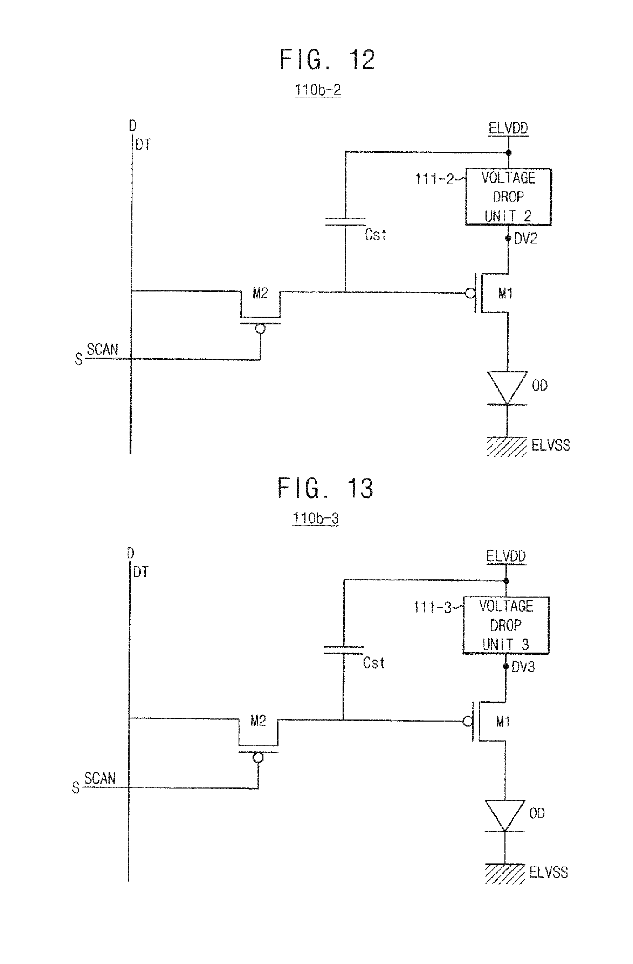

FIG. 11 is a circuit diagram illustrating another example of a red pixel included in the organic light emitting display device 10, FIG. 12 is a circuit diagram illustrating another example of a green pixel included in the organic light emitting display device 10, and FIG. 13 is a circuit diagram illustrating another example of a blue pixel included in the organic light emitting display device 10.

Referring to FIG. 11, a red pixel 110b-1 may receive the scan signal SCAN from the scan driver 200 of FIG. 1 through the scan line S. The red pixel 110b-1 may receive the data signal DT from the data driver 300 of FIG. 1 through the data line D. The red pixel 110b-1 may receive the common supply voltage ELVDD from the voltage generation unit 400 of FIG. 1 through the power line PL.

The red pixel 110b-1 may include an organic light emitting diode OD, a p-type metal oxide semiconductor (PMOS) transistor M1, a PMOS transistor M2, a voltage drop unit 111-1 and a storage capacitor Cst.

The organic light emitting diode OD may include a cathode connected to the ground voltage ELVSS and an anode coupled to a second electrode of the PMOS transistor M1.

The PMOS transistor M1 may include a first electrode coupled to the voltage drop unit 111-1, the second electrode coupled to the anode of the organic light emitting diode OD, and a gate electrode coupled to a second electrode of the PMOS transistor M2. The PMOS transistor M1 may operate as a driving transistor.

The voltage drop unit 111-1 may be coupled between the common supply voltage ELVDD and the first electrode of the PMOS transistor M1. The voltage drop unit 111-1 may generate a drive voltage DV1 by dropping a voltage of the common supply voltage ELVDD and provide the drive voltage DV1 to the first electrode of the PMOS transistor M1.

The PMOS transistor M2 may include a first electrode coupled to the data line D, the second electrode coupled to the gate electrode of the PMOS transistor M1, and a gate electrode coupled to the scan line S. The PMOS transistor M2 may operate as a switching transistor.

The storage capacitor Cst may include a first electrode coupled to the gate electrode of the PMOS transistor M1 and a second electrode connected to the common supply voltage ELVDD.

Referring to FIG. 12, a green pixel 110b-2 may receive the scan signal SCAN from the scan driver 200 of FIG. 1 through the scan line S. The green pixel 110b-2 may receive the data signal DT from the data driver 300 of FIG. 1 through the data line D. The green pixel 110b-2 may receive the common supply voltage ELVDD from the voltage generation unit 400 of FIG. 1 through the power line PL.

The green pixel 110b-2 may include an organic light emitting diode OD, a p-type metal oxide semiconductor (PMOS) transistor M1, a PMOS transistor M2, a voltage drop unit 111-2 and a storage capacitor Cst.

The green pixel 110b-2 of FIG. 12 may have the same structure as the red pixel 110b-1 of FIG. 11 except that the green pixel 110b-2 includes the voltage drop unit 111-2 instead of the voltage drop unit 111-1. A structure and an operation of the red pixel 110b-1 of FIG. 11 are described above with reference to FIGS. 1 and 11. Therefore, a duplicated description of the green pixel 110b-2 of FIG. 12 will be omitted.

The voltage drop unit 111-2 may be coupled between the common supply voltage ELVDD and the first electrode of the PMOS transistor M1. The voltage drop unit 111-2 may generate a drive voltage DV2 by dropping a voltage of the common supply voltage ELVDD and provide the drive voltage DV2 to the first electrode of the PMOS transistor M1. A voltage of the drive voltage DV2 generated by the voltage drop unit 111-2 may be different from a voltage of the drive voltage DV1 generated by the voltage drop unit 111-1.

Referring to FIG. 13, a blue pixel 110b-3 may receive the scan signal SCAN from the scan driver 200 of FIG. 1 through the scan line S. The blue pixel 110b-3 may receive the data signal DT from the data driver 300 of FIG. 1 through the data line D. The blue pixel 110b-3 may receive the common supply voltage ELVDD from the voltage generation unit 400 of FIG. 1 through the power line PL.

The blue pixel 110b-3 may include an organic light emitting diode OD, a p-type metal oxide semiconductor (PMOS) transistor M1, a PMOS transistor M2, a voltage drop unit 111-3 and a storage capacitor Cst.

The blue pixel 110b-3 of FIG. 13 may have the same structure as the red pixel 110b-1 of FIG. 11 except that the blue pixel 110b-3 includes the voltage drop unit 111-3 instead of the voltage drop unit 111-1. A structure and an operation of the red pixel 110b-1 of FIG. 11 are described above with reference to FIGS. 1 and 11. Therefore, a duplicated description of the blue pixel 110b-3 of FIG. 13 will be omitted.

The voltage drop unit 111-3 may be coupled between the common supply voltage ELVDD and the first electrode of the PMOS transistor M1. The voltage drop unit 111-3 may generate a drive voltage DV3 by dropping a voltage of the common supply voltage ELVDD and provide the drive voltage DV3 to the first electrode of the PMOS transistor M1. A voltage of the drive voltage DV3 generated by the voltage drop unit 111-3 may be different from a voltage of the drive voltage DV1 generated by the voltage drop unit 111-1 and a voltage of the drive voltage DV2 generated by the voltage drop unit 111-2.

The voltage drop unit 111-1, the voltage drop unit 111-2 and the voltage drop unit 111-3 may provide loads having different resistances from each other between the common supply voltage ELVDD and the first electrode of the PMOS transistor M1, so that the voltage drop unit 111-1, the voltage drop unit 111-2 and the voltage drop unit 111-3 may generate the drive voltage DV1, the drive voltage DV2 and the drive voltage DV3, respectively, having different voltages from each other.

Hereinafter, operations of the red pixel 110b-1, the green pixel 110b-2 and the blue pixel 110b-3 will be described with reference to FIGS. 1 and 11 to 13.

When the PMOS transistor M2, which operates as a switching transistor, is turned on in response to the scan signal SCAN provided from the scan driver 200 through the scan line S, the data signal DT provided from the data driver 300 through the data line D may be applied to the gate electrode of the PMOS transistor M1 and to the first electrode of the storage capacitor Cst.

The storage capacitor Cst may store a voltage difference between the common supply voltage ELVDD and the data signal DT.

When the data signal DT is in a logic low level, the PMOS transistor M1, which operates as a driving transistor, may be turned on. In the red pixel 110b-1, the drive voltage DV1 may be applied to the anode of the organic light emitting diode OD so that the organic light emitting diode OD emits light with a luminance corresponding to a voltage of the drive voltage DV1. In the green pixel 110b-2, the drive voltage DV2 may be applied to the anode of the organic light emitting diode OD so that the organic light emitting diode OD emits light with a luminance corresponding to a voltage of the drive voltage DV2. In the blue pixel 110b-3, the drive voltage DV3 may be applied to the anode of the organic light emitting diode OD so that the organic light emitting diode OD emits light with a luminance corresponding to a voltage of the drive voltage DV3.

When the data signal DT is in a logic high level, the PMOS transistor M1, which operates as a driving transistor, may be turned off so that the organic light emitting diode OD does not emit light.

As described above, one frame may include the predetermined number of sub-frames, and the red pixel 110b-1, the green pixel 110b-2 and the blue pixel 110b-3 may selectively emit light during each sub-frame based on a logic level of the data signal DT. Therefore, the organic light emitting display device 10 may display a gray scale by controlling a light emitting duration of the red pixel 110b-1, the green pixel 110b-2 and the blue pixel 110b-3 in one frame based on the data signal DT.

In addition, the red pixel 110b-1 may include the voltage drop unit 111-1 that generates the drive voltage DV1 by dropping a voltage of the common supply voltage ELVDD, the green pixel 110b-2 may include the voltage drop unit 111-2 that generates the drive voltage DV2 by dropping a voltage of the common supply voltage ELVDD, and the blue pixel 110b-3 may include the voltage drop unit 111-3 that generates the drive voltage DV3 by dropping a voltage of the common supply voltage ELVDD. Therefore, the organic light emitting display device 10 may adjust a white balance by independently controlling luminance of the light emitted from the red pixel 110b-1, the green pixel 110b-2 and the blue pixel 110b-3 using the voltage drop unit 111-1, the voltage drop unit 111-2 and the voltage drop unit 111-3, respectively.

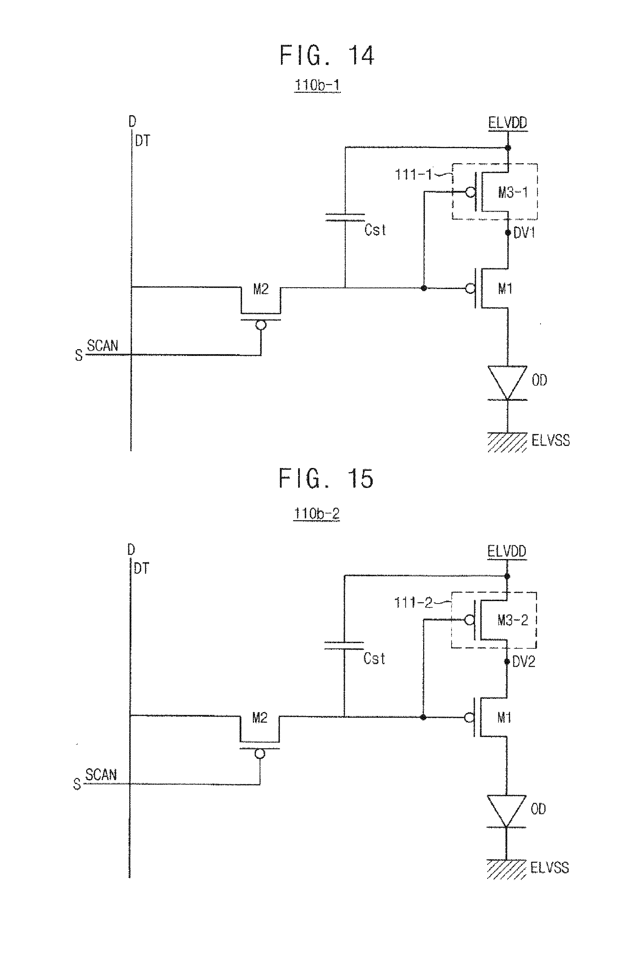

FIGS. 14, 15 and 16 are circuit diagrams illustrating an example of a voltage drop unit included in pixels of FIGS. 11, 12 and 13, respectively.

Referring to FIG. 14, the voltage drop unit 111-1 may include a PMOS transistor M3-1 having a first electrode connected to the common supply voltage ELVDD, a second electrode coupled to the first electrode of the PMOS transistor M1 and a gate electrode coupled to the second electrode of the PMOS transistor M2.

Referring to FIG. 15, the voltage drop unit 111-2 may include a PMOS transistor M3-2 having a first electrode connected to the common supply voltage ELVDD, a second electrode coupled to the first electrode of the PMOS transistor M1 and a gate electrode coupled to the second electrode of the PMOS transistor M2.

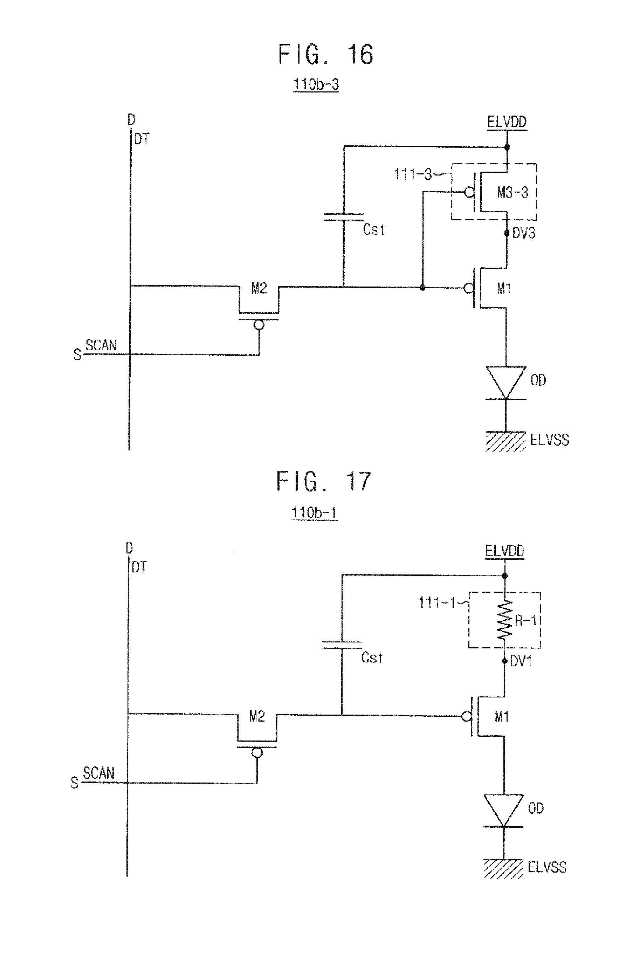

Referring to FIG. 16, the voltage drop unit 111-3 may include a PMOS transistor M3-3 having a first electrode connected to the common supply voltage ELVDD, a second electrode coupled to the first electrode of the PMOS transistor M1 and a gate electrode coupled to the second electrode of the PMOS transistor M2.

Aspect ratios of the PMOS transistor M3-1, the PMOS transistor M3-2 and the PMOS transistor M3-3 may be different from each other. An aspect ratio of a MOS transistor represents a ratio of a channel width to a channel length.

When the data signal DT is in a logic low level, the PMOS transistor M3-1, the PMOS transistor M3-2 and the PMOS transistor M3-3 may be turned on. Therefore, the PMOS transistor M3-1, the PMOS transistor M3-2 and the PMOS transistor M3-3 may generate the drive voltage DV1, the drive voltage DV2 and the drive voltage DV3, respectively, having different voltages from each other by providing loads having different resistances from each other between the common supply voltage ELVDD and the first electrode of the PMOS transistor M1. The PMOS transistor M3-1, the PMOS transistor M3-2 and the PMOS transistor M3-3 may provide the drive voltage DV1, the drive voltage DV2 and the drive voltage DV3, respectively, to the first electrode of the PMOS transistor M1.

FIGS. 17, 18 and 19 are circuit diagrams illustrating another example of a voltage drop unit included in pixels of FIGS. 11, 12 and 13, respectively.

Referring to FIG. 17, the voltage drop unit 111-1 may include a resistor R-1 coupled between the common supply voltage ELVDD and the first electrode of the PMOS transistor M1.

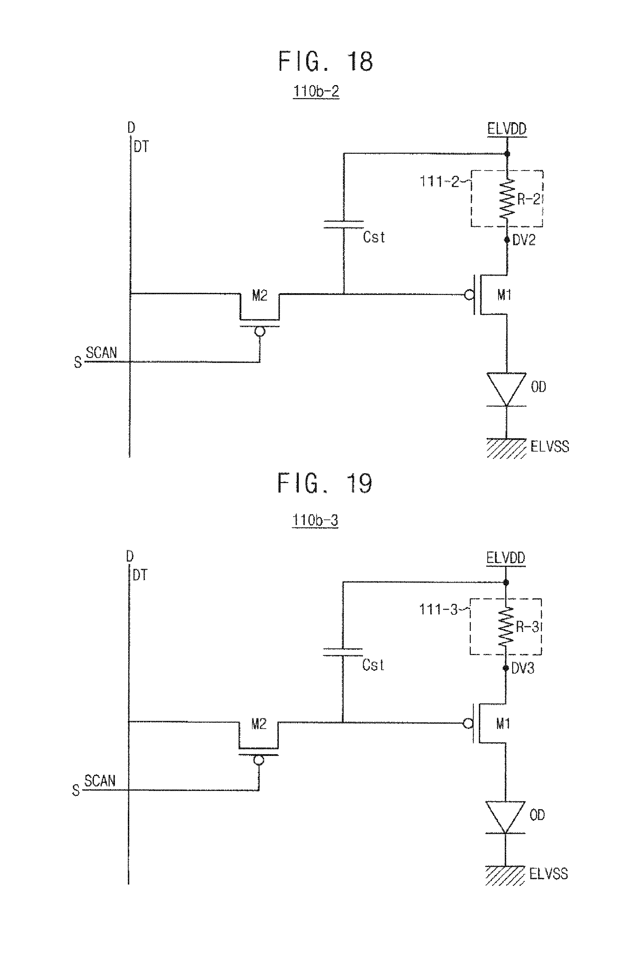

Referring to FIG. 18, the voltage drop unit 111-2 may include a resistor R-2 coupled between the common supply voltage ELVDD and the first electrode of the PMOS transistor M1.

Referring to FIG. 19, the voltage drop unit 111-3 may include a resistor R-3 coupled between the common supply voltage ELVDD and the first electrode of the PMOS transistor M1.

Resistance values of the resistor R-1, the resistor R-2 and the resistor R-3 may be different from each other.

Therefore, the resistor R-1, the resistor R-2 and the resistor R-3 may generate the drive voltage DV1, the drive voltage DV2 and the drive voltage DV3, respectively, having different voltages from each other by providing loads having different resistances from each other between the common supply voltage ELVDD and the first electrode of the PMOS transistor M1. The resistor R-1, the resistor R-2 and the resistor R-3 may provide the drive voltage DV1, the drive voltage DV2 and the drive voltage DV3, respectively, to the first electrode of the PMOS transistor M1.

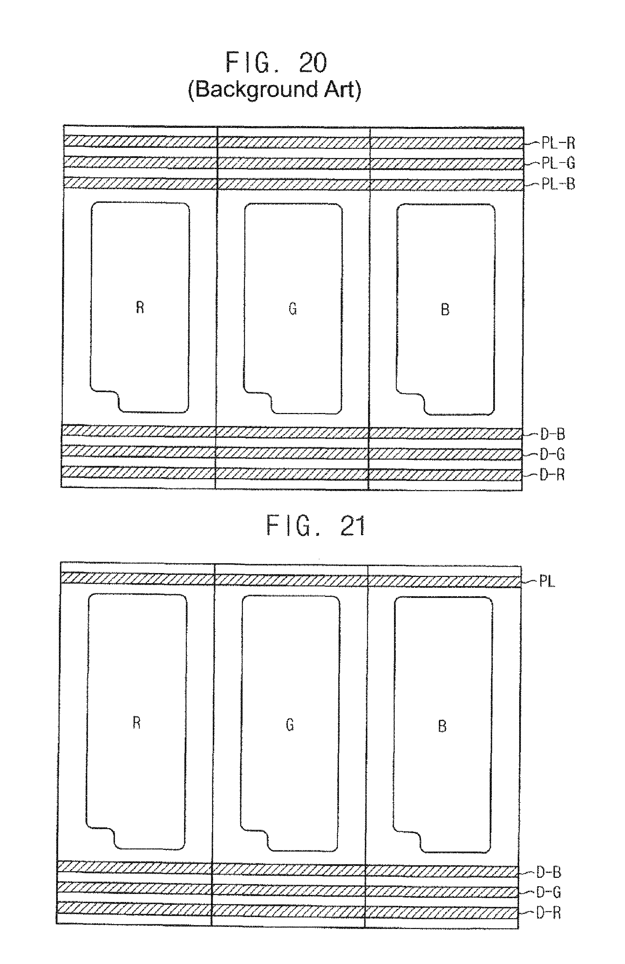

FIGS. 20 and 21 are diagrams for describing advantages of an organic light emitting display device of FIG. 1.

FIG. 20 represents a layout of pixels in a conventional organic light emitting display device that is driven in a digital manner, and FIG. 21 represents a layout of pixels in the organic light emitting display device 10 according to example embodiments.

Referring to FIG. 20, a red data line D-R, a green data line D-G and a blue data line D-B are formed in each of the red pixel R, the green pixel G and the blue pixel B. The red data line D-R transmits a data signal for the red pixel R, the green data line D-G transmits a data signal for the green pixel G, and the blue data line D-B transmits a data signal for the blue pixel B. The red pixel R is coupled to the red data line D-R, the green pixel G is coupled to the green data line D-G, and the blue pixel B is coupled to the blue data line D-B (not illustrated in FIG. 20).

As described above, the conventional organic light emitting display device uses an independent supply voltage for each of the red pixel, the green pixel and the blue pixel to adjust a white balance. Therefore, the background art of FIG. 20 illustrates, a red power line PL-R, a green power line PL-G and a blue power line PL-B are formed in each of the red pixel R, the green pixel G and the blue pixel B. The red power line PL-R transmits a supply voltage for the red pixel R, the green power line PL-G transmits a supply voltage for the green pixel G, and the blue power line PL-B transmits a supply voltage for the blue pixel B. The red pixel R is coupled to the red power line PL-R, the green pixel G is coupled to the green power line PL-G, and the blue pixel B is coupled to the blue power line PL-B (not illustrated in FIG. 20).

As such, in the organic light emitting display device, an aperture ratio may be reduced since the three power lines PL-R, PL-G, PL-B are formed in each of pixels.

Referring to FIG. 21, a red data line D-R, a green data line D-G and a blue data line D-B are formed in each of the red pixel R, the green pixel G and the blue pixel B, as in the case of the organic light emitting display device of FIG. 20.

However, the organic light emitting display device 10 according to example embodiments uses the common supply voltage ELVDD for each of the red pixel, the green pixel and the blue pixel. Therefore, as illustrated in FIG. 21, one power line PL, which transmits the common supply voltage ELVDD, is formed in the red pixel R, the green pixel G and the blue pixel B. All of the red pixel R, the green pixel G and the blue pixel B are coupled to the one power line PL (not illustrated in FIG. 21).

As such, in the organic light emitting display device 10 according to example embodiments, an aperture ratio may be increased since only one power line PL is formed in each of pixels.

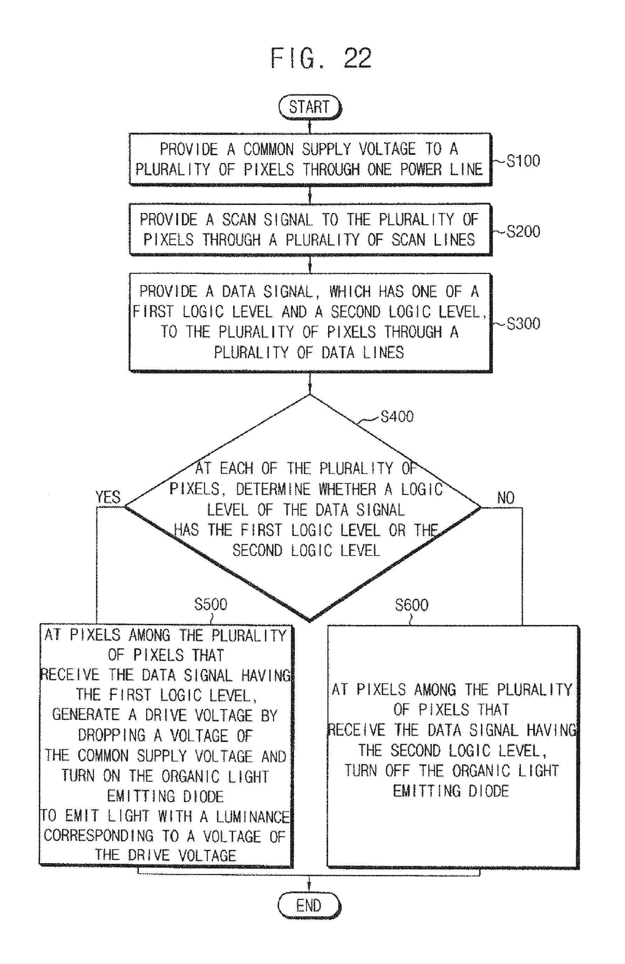

FIG. 22 is a flow chart illustrating a method of driving an organic light emitting display device according to example embodiments.

FIG. 22 represents a method of driving an organic light emitting display device that includes a plurality of pixels coupled to a plurality of scan lines and a plurality of data lines and including an organic light emitting diode.

Referring to FIG. 22, a common supply voltage is provided to the plurality of pixels through one power line (step S100), a scan signal is provided to the plurality of pixels through the plurality of scan lines (step S200), and a data signal is provided to the plurality of pixels through the plurality of data lines (step S300). The data signal may have one of a first logic level and a second logic level. The first logic level may be a logic high level and the second logic level may be a logic low level. Alternatively, the first logic level may be a logic low level and the second logic level may be a logic high level.

In some example embodiments, the step S100, the step S200 and the step S300 may be performed in a different order from that of FIG. 22. In other example embodiments, the step S100, the step S200 and the step S300 may be performed simultaneously.

Each of the plurality of pixels determines whether a logic level of the data signal has the first logic level or the second logic level (step S400).

Pixels among the plurality of pixels that receive the data signal having the first logic level generates a drive voltage by dropping a voltage of the common supply voltage and turns on the organic light emitting diode to emit light with a luminance corresponding to a voltage of the drive voltage (step S500).

Pixels among the plurality of pixels that receive the data signal having the second logic level turns off the organic light emitting diode not to emit light (step S600).

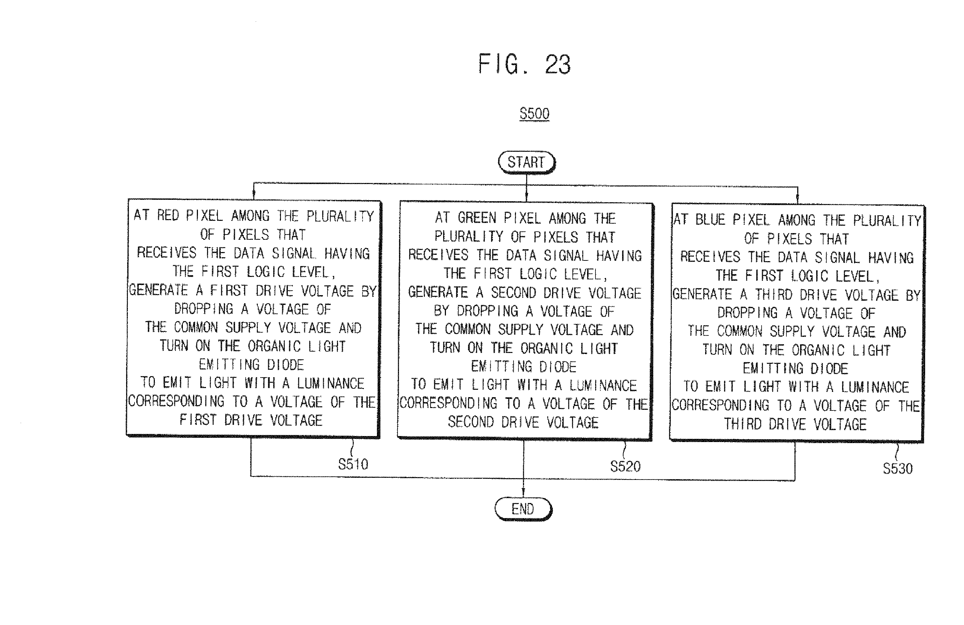

FIG. 23 is a flow chart illustrating an example of a step of generating a drive voltage and turning on the organic light emitting diode in a method of FIG. 22.

Referring to FIG. 23, a red pixel among the plurality of pixels that receives the data signal having the first logic level may generate a first drive voltage by dropping a voltage of the common supply voltage and turn on the organic light emitting diode to emit light with a luminance corresponding to a voltage of the first drive voltage (step S510).

A green pixel among the plurality of pixels that receives the data signal having the first logic level may generate a second drive voltage by dropping a voltage of the common supply voltage and turn on the organic light emitting diode to emit light with a luminance corresponding to a voltage of the second drive voltage (step S520).

A blue pixel among the plurality of pixels that receives the data signal having the first logic level may generate a third drive voltage by dropping a voltage of the common supply voltage and turn on the organic light emitting diode to emit light with a luminance corresponding to a voltage of the third drive voltage (step S530).

The first drive voltage, the second drive voltage and the third drive voltage may have different voltages from each other.

In some example embodiments, the red pixel may generate the first drive voltage by dropping a voltage of the common supply voltage using a first MOS transistor, the green pixel may generate the second drive voltage by dropping a voltage of the common supply voltage using a second MOS transistor, and the blue pixel may generate the third drive voltage by dropping a voltage of the common supply voltage using a third MOS transistor. Aspect ratios of the first MOS transistor, the second MOS transistor and the third MOS transistor may be different from each other, so that the first MOS transistor, the second MOS transistor and the third MOS transistor may generate the first drive voltage, the second drive voltage and the third drive voltage, respectively, having different voltages from each other.

In other example embodiments, the red pixel may generate the first drive voltage by dropping a voltage of the common supply voltage using a first resistor, the green pixel may generate the second drive voltage by dropping a voltage of the common supply voltage using a second resistor, and the blue pixel may generate the third drive voltage by dropping a voltage of the common supply voltage using a third resistor. Resistances of the first resistor, the second resistor and the third resistor may be different from each other, so that the first resistor, the second resistor and the third resistor may generate the first drive voltage, the second drive voltage and the third drive voltage, respectively, having different voltages from each other.

The method of driving an organic light emitting display device of FIG. 22 may be performed by the organic light emitting display device 10 of FIG. 1. A structure and an operation of the organic light emitting display device 10 of FIG. 1 are described above with reference to FIGS. 1 to 21. Thus, a detailed description of the steps of the method of FIG. 22 will be omitted.

As described above, in the method of driving an organic light emitting display device according to example embodiments, the common supply voltage is provided to all of the red pixel, the green pixel and the blue pixel, and the red pixel, the green pixel and the blue pixel generate the drive voltages having different voltages from each other by dropping a voltage of the common supply voltage. Therefore, in the method of driving an organic light emitting display device, a white balance may be adjusted using one supply voltage. As such, an aperture ratio may be increased, a dead space may be reduced, and a short between wirings may be reduced since only one power line is formed on the pixel unit.

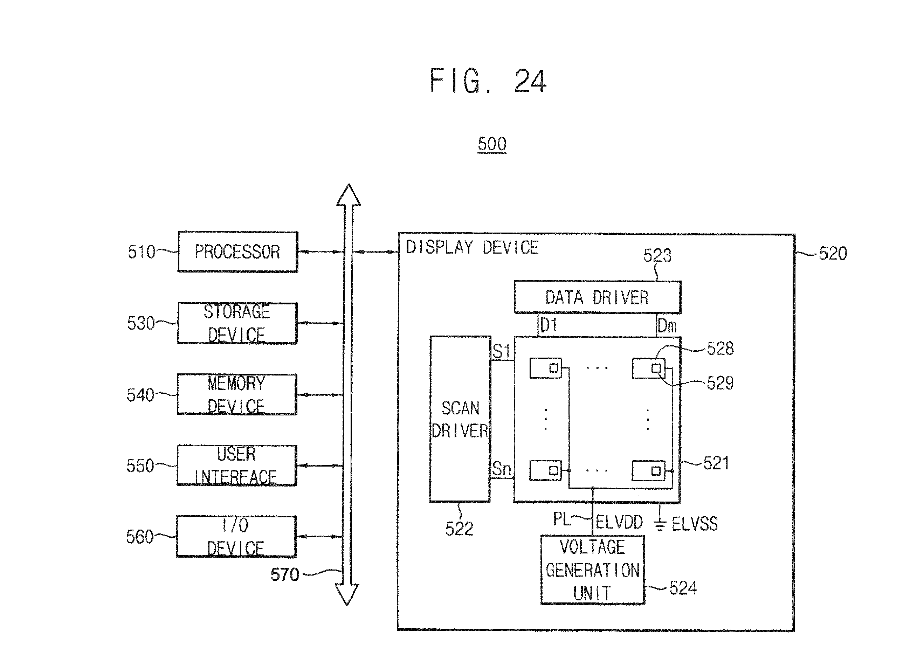

FIG. 24 is a block diagram illustrating a system including an organic light emitting display device according to example embodiments.

Referring to FIG. 24, a system 500 includes a processor 510, an organic light emitting display device 520 and a storage device 530.

The storage device 530 stores video data. The storage device 530 may include a solid state drive (SSD), a hard disk drive (HHD), a CD-ROM, a non-volatile memory device, etc.

The processor 510 controls operations of the storage device 530 and the organic light emitting display device 520. For example, the processor 510 may read the video data from the storage device 530 and provide the video data to the organic light emitting display device 520.

The organic light emitting display device 520 displays the video data received from the processor 510.

The display device 520 includes a pixel unit 521, a scan driver 522, a data driver 523 and a voltage generation unit 524.

The pixel unit 521 is coupled to the scan driver 522 through a plurality of scan lines S1, ..., Sn. The pixel unit 521 is coupled to the data driver 523 through a plurality of data lines D1, ..., Dm. The pixel unit 521 is coupled to the voltage generation unit 524 through one power line PL. The pixel unit 521 is connected to a ground voltage ELVSS.

The pixel unit 521 includes a plurality of pixels 528 coupled to the plurality of scan lines S1, ..., Sn and the plurality of data lines D1, ..., Dm. Each of the plurality of pixels 528 includes an organic light emitting diode.

The scan driver 522 provides a scan signal to the plurality of pixels 528 through the plurality of scan lines S1, ..., Sn.

The data driver 523 provides a data signal to the plurality of pixels 528 through the plurality of data lines D1, ..., Dm. The data signal has one of a first logic level and a second logic level. The first logic level may be a logic high level and the second logic level may be a logic low level. Alternatively, the first logic level may be a logic low level and the second logic level may be a logic high level.

The voltage generation unit 524 generates a common supply voltage ELVDD and provides the common supply voltage ELVDD to the plurality of pixels 528 through the one power line PL.

Each of the plurality of pixels 528 receives the common supply voltage ELVDD from the voltage generation unit 524 and turns on the organic light emitting diode to emit light using the common supply voltage ELVDD.

In some example embodiments, each of the plurality of pixels 528 may include a voltage drop unit 529 that generates a drive voltage by dropping a voltage of the common supply voltage ELVDD. Each of the plurality of pixels 528 may turn on the organic light emitting diode to emit light with a luminance corresponding to a voltage of the drive voltage based on a logic level of the data signal.

The plurality of pixels 528 may include a red pixel, a green pixel and a blue pixel. The voltage drop units 529 included in the red pixel, the green pixel and the blue pixel may generate the drive voltages having different voltages from each other using the common supply voltage ELVDD. Therefore, luminance of the light emitted from the red pixel, the green pixel and the blue pixel may be determined differently from each other, so that the organic light emitting display device 520 may adjust a white balance using one supply voltage ELVDD.

The red pixel, the green pixel and the blue pixel included in the plurality of pixels 528 may be embodied with the red pixel 110a-1 in FIG. 2, the green pixel 110a-2 in FIG. 3 and the blue pixel 110a-3 in FIG. 4 or the red pixel 110b-1 in FIG. 11, the green pixel 110b-2 in FIG. 12 and the blue pixel 110b-3 in FIG. 13, respectively. A structure and an operation of the red pixel 110a-1, the green pixel 110a-2, the blue pixel 110a-3, the red pixel 110b-1, the green pixel 110b-2 and the blue pixel 110b-3 are described above with reference to FIGS. 1 to 21. Therefore, a detailed description of the plurality of pixels 528 will be omitted.

The processor 510 may perform specific calculations, or computing functions for various tasks. For example, the processor 510 may include a microprocessor, a central processing unit (CPU), etc. The processor 510 may be coupled to the storage device 530 and the organic light emitting display device 520 via an address bus, a control bus, and/or a data bus. In addition, the processor 510 may be coupled to an extended bus such as a peripheral component interconnection (PCI) bus.

The processor 510 may be embodied as a single core architecture or a multi core architecture. For example, the processor 510 may be embodied as a single core architecture when an operating frequency of the processor 510 is less than 1 GHz, and the processor 510 may be embodied as a multi core architecture when an operating frequency of the processor 510 is greater than 1 GHz. The processor 510 that is embodied as a multi core architecture may communicate with peripheral devices via an advanced extensible interface (AXI) bus 570.

The system 500 may further include a memory device 540, a user interface 550 and an I/O device 560. In some example embodiments, the system 500 may further include a plurality of ports (not illustrated) that communicate with a video card, a sound card, a memory card, a universal serial bus (USB) device, other electric devices, etc.

The memory device 540 may store data for operations of the system 500. For example, the memory device 540 may include at least one volatile memory device such as a dynamic random access memory (DRAM) device, a static random access memory (SRAM) device, etc. and/or at least one non-volatile memory device such as an erasable programmable read-only memory (EPROM) device, an electrically erasable programmable read-only memory (EEPROM) device, a flash memory device, etc.

The user interface 550 may include devices required for a user to control the system 500. The I/O device 560 may include at least one input device (e.g., a keyboard, keypad, a mouse, a touch screen, etc.), and/or at least one output device (e.g., a printer, a speaker, etc.).

The system 500 may include any of several types of electronic devices, such as a digital television, a cellular phone, a smart phone, a personal digital assistant (PDA), a personal media player (PMP), a portable game console, a computer monitor, a digital camera, a MP3 player, etc.

The foregoing is illustrative of the present inventive concept and is not to be construed as limiting thereof. Although a few example embodiments have been described, those skilled in the art will readily appreciate that many modifications are possible without materially departing from the present invention as defined in the appended claims.

## Claims

1. An organic light emitting display device, comprising:
a pixel unit including a plurality of pixels coupled to a plurality of scan lines and a plurality of data lines, each of the plurality of pixels including an organic light emitting diode, the organic light emitting diode being configured to be turned on to emit light using a common supply voltage;
a scan driver configured to provide a scan signal to the plurality of pixels through the plurality of scan lines;
a data driver configured to provide a data signal to the plurality of pixels through the plurality of data lines, the data signal having one of a first logic level and a second logic level; and
a voltage generation unit coupled to the pixel unit through one power line, the voltage generation unit being configured to provide the common supply voltage to the plurality of pixels through the one power line.

2. The organic light emitting display device of claim 1, wherein each of the plurality of pixels includes a voltage drop unit, each voltage drop unit configured to generate a respective drive voltage by dropping a voltage of the common supply voltage, and to turn on the organic light emitting diode to emit light with a luminance corresponding to a voltage of the drive voltage based on a logic level of the data signal.

3. The organic light emitting display device of claim 2, wherein the plurality of pixels include a red pixel, a green pixel and a blue pixel, and
wherein the voltage drop units included in the red pixel, the green pixel and the blue pixel generate the respective drive voltages, the respective drive voltages having different voltages from each other.

4. The organic light emitting display device of claim 3, wherein the voltage drop unit comprises:
a metal oxide semiconductor (MOS) transistor connected to the common supply voltage; or
a resistor connected to the common supply voltage.

5. The organic light emitting display device of claim 4, wherein aspect ratios of the MOS transistors included in the red pixel, the green pixel and the blue pixel are different from each other, or
wherein resistances of the resistors included in the red pixel, the green pixel and the blue pixel are different from each other.

6. The organic light emitting display device of claim 1, wherein each of the pixels comprises:
an organic light emitting diode having a cathode connected to a ground voltage;
a first p-type metal oxide semiconductor (PMOS) transistor having a gate electrode, a first electrode and a second electrode coupled to an anode of the organic light emitting diode;
a voltage drop unit generating a drive voltage by dropping a voltage of the common supply voltage and providing the drive voltage to the first electrode of the first PMOS transistor;
a second PMOS transistor having a first electrode coupled to the data line, a second electrode coupled to the gate electrode of the first PMOS transistor and a gate electrode coupled to the scan line; and
a storage capacitor coupled between the gate electrode of the first PMOS transistor and the first electrode of the first PMOS transistor.

7. The organic light emitting display device of claim 6, wherein the plurality of pixels include a red pixel, a green pixel and a blue pixel, and
wherein the voltage drop units included in the red pixel, the green pixel and the blue pixel generate the drive voltages having different voltages from each other.

8. The organic light emitting display device of claim 7, wherein the voltage drop units included in the red pixel, the green pixel and the blue pixel provide loads having different resistances from each other between the common supply voltage and the first electrode of the first PMOS transistor.

9. The organic light emitting display device of claim 7, wherein the voltage drop unit comprises:
a third PMOS transistor having a first electrode connected to the common supply voltage, a second electrode coupled to the first electrode of the first PMOS transistor and a gate electrode coupled to the second electrode of the second PMOS transistor; or
a resistor coupled between the common supply voltage and the first electrode of the first PMOS transistor.

10. The organic light emitting display device of claim 9, wherein aspect ratios of the third PMOS transistors included in the red pixel, the green pixel and the blue pixel are different from each other, or
wherein resistances of the resistors included in the red pixel, the green pixel and the blue pixel are different from each other.

11. The organic light emitting display device of claim 1, wherein each of the plurality of pixels comprises:
an organic light emitting diode having a cathode connected to a ground voltage;
a first p-type metal oxide semiconductor (PMOS) transistor having a gate electrode, a first electrode and a second electrode coupled to an anode of the organic light emitting diode;
a voltage drop unit generating a drive voltage by dropping a voltage of the common supply voltage and providing the drive voltage to the first electrode of the first PMOS transistor;
a second PMOS transistor having a first electrode coupled to the data line, a second electrode coupled to the gate electrode of the first PMOS transistor and a gate electrode coupled to the scan line; and
a storage capacitor coupled between the gate electrode of the first PMOS transistor and the common supply voltage.

12. A method of driving an organic light emitting display device that includes a plurality of pixels coupled to a plurality of scan lines and a plurality of data lines and including an organic light emitting diode, comprising:
providing a common supply voltage to the plurality of pixels through one power line;
providing a scan signal to the plurality of pixels through the plurality of scan lines;
providing a data signal to the plurality of pixels through the plurality of data lines, the data signal having one of a first logic level and a second logic level;
at pixels among the plurality of pixels that receive the data signal having the first logic level, generating a drive voltage by dropping a voltage of the common supply voltage and turning on the organic light emitting diode to emit light with a luminance corresponding to a voltage of the drive voltage; and
at pixels among the plurality of pixels that receive the data signal having the second logic level, turning off the organic light emitting diode.

13. The method of claim 12, wherein the plurality of pixels include a red pixel, a green pixel and a blue pixel, and
wherein generating the drive voltage by dropping a voltage of the common supply voltage and turning on the organic light emitting diode to emit light with a luminance corresponding to a voltage of the drive voltage comprises:
at the red pixel that receives the data signal having the first logic level, generating a first drive voltage by dropping a voltage of the common supply voltage and turning on the organic light emitting diode to emit light with a luminance corresponding to a voltage of the first drive voltage;
at the green pixel that receives the data signal having the first logic level, generating a second drive voltage by dropping a voltage of the common supply voltage and turning on the organic light emitting diode to emit light with a luminance corresponding to a voltage of the second drive voltage; and
at the blue pixel that receives the data signal having the first logic level, generating a third drive voltage by dropping a voltage of the common supply voltage and turning on the organic light emitting diode to emit light with a luminance corresponding to a voltage of the third drive voltage.

14. The method of claim 13, wherein the red pixel generates the first drive voltage by dropping a voltage of the common supply voltage using a first MOS transistor, the green pixel generates the second drive voltage by dropping a voltage of the common supply voltage using a second MOS transistor, and the blue pixel generates the third drive voltage by dropping a voltage of the common supply voltage using a third MOS transistor, and
wherein aspect ratios of the first MOS transistor, the second MOS transistor and the third MOS transistor are different from each other.

15. The method of claim 13, wherein the red pixel generates the first drive voltage by dropping a voltage of the common supply voltage using a first resistor, the green pixel generates the second drive voltage by dropping a voltage of the common supply voltage using a second resistor, and the blue pixel generates the third drive voltage by dropping a voltage of the common supply voltage using a third resistor, and
wherein resistances of the first resistor, the second resistor and the third resistor are different from each other.
